# EUROPEAN PATENT SPECIFICATION

(11) **EP 4 296 805 B1**
(45) Date of publication and mention of the grant of the patent: **09.12.2026**
(21) Application number: 22775184.9
(22) Date of filing: 11.03.2022
(51) Int. Cl.: G05B 19/05, G06F 1/18, H05K 7/14

(54) **ELECTRONIC APPARATUS**
ELEKTRONISCHES GERÄT
APPAREIL ÉLECTRONIQUE

(30) Priority: 24.03.2021 JP 2021050066
(43) Date of publication of application: 27.12.2023
(73) Proprietor: FANUC CORPORATION, Oshino-mura Minamitsuru-gun Yamanashi 401-0597 (JP)
(72) Inventor: SAEKI Masahiro, 401-0597 Yamanashi (JP); KUWAHATA Shinichi, 401-0597 Yamanashi (JP); MAEDA Asunaro, 401-0597 Yamanashi (JP)
(74) Representative: Keil & Schaafhausen Patentanwälte PartGmbB
(86) International application number: PCT/JP2022/010779
(87) International publication number: WO 2022/202392

(56) References cited:
- EP-A1- 3 771 962
- JP-A- 2004 038 743
- JP-A- 2014 228 900
- JP-A- 2016 110 460
- JP-A- H0 865 918
- US-A1- 2012 044 082
- US-A1- 2020 251 888
- US-A1- 2020 396 857

## Description

### TECHNICAL FIELD

The present invention relates to an electronic device (electronic apparatus).

### BACKGROUND ART

JP 2016 - 110 460 A discloses a programmable logic controller system. The programmable logic controller system includes a base unit (master) and a plurality of expansion units (electronic device). The plurality of electronic devices are slaves of the base unit. The base unit transmits and receives signals to and from a controlled device via the plurality of electronic devices. The plurality of electronic devices are arranged in series with the base unit being at the head. The controlled device is a device such as a sensor or an actuator, for example.

US 2020/396857 A1, US 2020/251888 A1, US 2012/044082 A1, and EP 3 771 962 A1 disclose further arrangements from the state of the art that are suitable for interconnecting electronic devices in a conductive manner.

### SUMMARY OF THE INVENTION

The electronic device outputs an output signal using power supplied from a power supply. The electronic devices include a model that receives electric power supplied from one power supply (common power supply) together with other electronic devices, and a model that receives electric power supplied from different power supplies (individual power supplies) for each electronic device.

There is a case in which the operator may want to select whether to supply electric power to a plurality of electronic devices from one power supply or to supply electric power to each electronic device from a different power supply individually, depending on the situation. However, in the conventional electronic device, there is a problem that the connection mode for the electronic device with the power supply is limited depending on the model of the electronic device, as described above.

The present invention has the object of solving the aforementioned problems.

This problem is solved by the electronic apparatus according to claim 1. Preferred embodiments of the invention are evident from the dependent claims.

According to the present invention, there is provided an electronic device capable of easily changing a connection mode to a power supply.

### BRIEF DESCRIPTION OF DRAWINGS

FIG. 1 is a diagram illustrating a communication system configured to include an electronic device according to an embodiment of the present invention;
FIG. 2 is a perspective view of the electronic device of FIG. 1;
FIG. 3 is a diagram representing a signal processing module of the electronic device of FIG. 2;
FIG. 4 is a view showing a state in which a conductive member is attached to the signal processing module of FIG. 3;
FIG. 5 is a diagram illustrating an electronic device provided with a conductive member according to a first modification;
FIG. 6 is a diagram illustrating an electronic device provided with a conductive member according to a first modification, which is an example different from FIG. 5;
FIG. 7 is a diagram illustrating a state in which a power supply is connected to an individual power terminal of an electronic device provided with a conductive member according to a second modification;
FIG. 8A is a diagram illustrating an electronic device according to a third modification; and
FIG. 8B is an exploded view of the electronic device of FIG. 8A.

### DETAILED DESCRIPTION OF THE INVENTION

### [Embodiments]

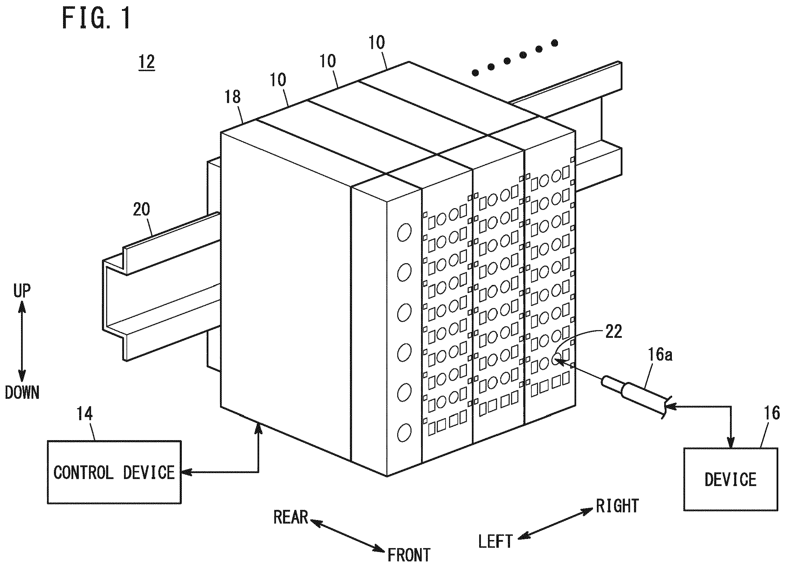

FIG. 1 is a diagram illustrating a communication system 12 configured to include an electronic device 10 according to an embodiment of the present invention. Arrows in FIG. 1 indicate directions (front, rear, left, right, up, and down) used for the following descriptions. The front-rear direction, the left-right direction, and the up-down direction are orthogonal to each other. The arrows in the other figures correspond to those in FIG. 1 unless otherwise indicated.

The communication system 12 is a system that transmits signals between a control device 14 and a device 16. The communication system 12 includes a communication coupler unit 18 and a plurality of electronic devices 10. The communication coupler unit 18 is a master unit. The plurality of electronic devices are slave units of the communication coupler unit 18. The electronic device 10 is, for example, an I/O unit (input/output unit).

The communication coupler unit 18 is connected to the control device 14. The control device 14 is an electronic device that controls a mechanical device such as a machine tool or a robot. The communication coupler unit 18 further includes a connection terminal that can be connected to the electronic device 10. The connection terminal is provided at a portion of the communication coupler unit 18 that is adjacent to the electronic device 10. Note that the connection terminal of the communication coupler unit 18 are not shown.

Each of the plurality of electronic devices 10 is connected to the device 16. The device 16 is, for example, an actuator such as a switch. The actuator is provided in, for example, the machine tool or the robot. The actuator operates in response to a signal input from the electronic device 10. In this regard, the device 16 includes a terminal (external terminal) 16a for connection with the electronic device 10. The device 16 may output a signal to the control device 14 via the electronic device 10.

The communication coupler unit 18 and the plurality of electronic devices 10 are arranged along the left-right direction. Here, the communication coupler unit 18 and the plurality of electronic devices 10 are installed on a predetermined installation member 20. The installation member 20 is, for example, a DIN rail. The installation member 20 of FIG. 1 extends along the left-right direction. Further, the installation member 20 is disposed behind the communication coupler unit 18 and the plurality of electronic devices 10.

The control device 14 and the device (s) 16 are connected via the communication system 12. The control device 14 transmits signals to the device 16 via the communication system 12. The control device 14 also receives signals from the device 16 via the communication system 12. Each of the communication coupler unit 18 and the electronic device 10 performs signal processing such that signals are appropriately transmitted and received between the control device 14 and the device 16. Descriptions on the details of the signal processing performed by the communication coupler unit 18 are omitted.

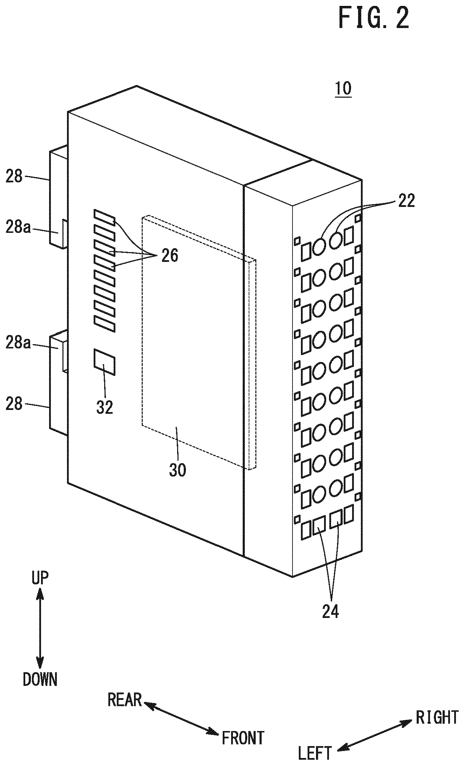

FIG. 2 is a perspective view of the electronic device 10 of FIG. 1.

The electronic device 10 preferably has a substantially flat plate shape that is thin in a direction (left-right direction) in which the communication coupler unit 18 and the other electronic devices 10 are arranged in series. Thus, the communication system 12 becomes compact in size. The electronic device 10 includes a plurality of inserted portions 22, a plurality of power connectors 24, a plurality of contactors 26, end engagement portions 28, a signal processing module 30, and a conductive member 32 (see FIG. 2).

The plurality of inserted portions 22 are provided on the front side of the electronic device 10. The plurality of external terminals 16a (see FIG. 1) are inserted into the plurality of inserted portions 22. Each of the plurality of inserted portions 22 is appropriately equipped with a terminal electrically connected to the inserted external terminal 16a. The terminal electrically connected to the external terminal 16a are not shown.

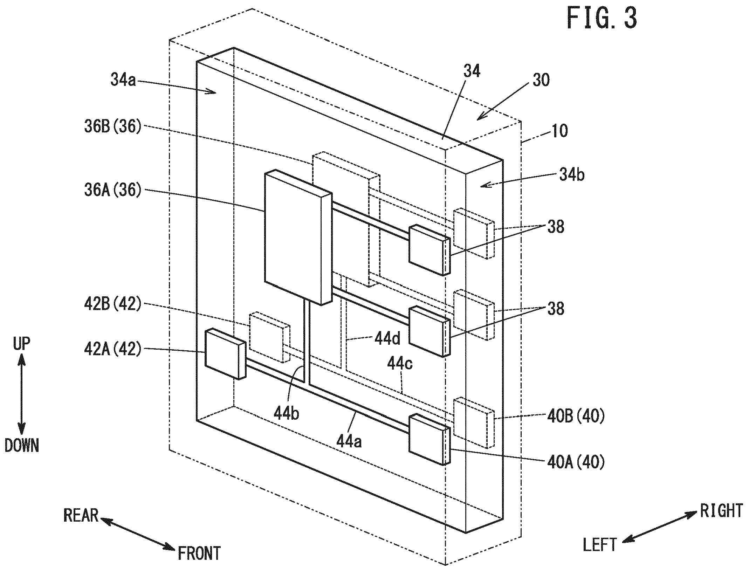

Each of the plurality of power connectors 24 is a connector for connecting to an external power supply. The plurality of power connectors 24 are provided on the front side of the electronic device 10, similarly to the plurality of inserted portions 22. The number of the power connectors 24 is the same as the number of individual power terminals 40 (see FIG. 3) described later. In FIGS. 1 and 2, the plurality of power connectors 24 are provided at the lowest portion of the electronic device 10, but the present invention is not limited to this.

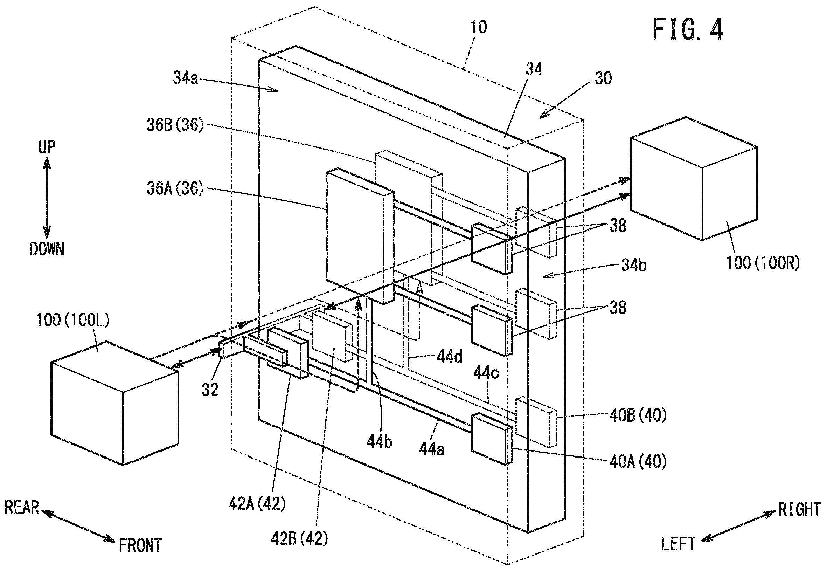

Each of the plurality of contactors 26 is a member for electrically connecting the electronic device 10 to another unit 100 (see also FIG. 4). The other unit 100 is another electronic device (10) adjacent to the electronic device 10 in the left-right direction or a communication coupler unit (18). One or more contactors 26 are provided on each of the left side of the electronic device 10 and the right side of the electronic device 10. Illustration of the right side of the electronic device 10 is omitted. The plurality of contactors 26 constitute a transmission path for inputting and outputting signals between the electronic device 10 and the other unit 100.

The end engagement portions 28 cause the electronic device 10 to engage with the installation member 20 (see FIG. 1). Each of the end engagement portions 28 includes, for example, a claw 28a. The claw 28a is engageable with the installation member 20. The end engagement portions 28 are provided at a rear portion of the electronic device 10.

The signal processing module 30 is a module (a group of electronic components or a circuit) configured to be electrically connected to the plurality of external terminals 16a and the other units 100. The signal processing module 30 inputs and outputs signals to and from the other unit 100 which is conducted thereto.

FIG. 3 is a diagram illustrating the signal processing module 30 of the electronic device 10 of FIG. 2.

The signal processing module 30 exemplified in the present embodiment includes a circuit board 34, a plurality of processing circuits 36, a plurality of signal output terminals 38, a plurality of individual power terminals 40, and a plurality of common power terminals 42. The plurality of processing circuits 36, the plurality of signal output terminals 38, the plurality of individual power terminals 40, and the plurality of common power terminals 42 are provided on the circuit board 34.

Each of the plurality of processing circuits (communication circuits) 36 includes, for example, a driver circuit and a control integrated circuit (IC) as appropriate. The driver circuit outputs a signal to the device 16 by using the supplied electric power. The control IC controls the supply of power to the driver circuit. Each of the plurality of processing circuits (in particular, the control ICs) 36 processes signals input from the other unit 100 through the contactor 26 and processes signals input from the device 16 through the external terminal 16a. Descriptions on a more specific configuration of the processing circuit 36 is omitted.

In the present embodiment, the number of the plurality of processing circuits 36 is two for illustration. The circuit board 34 has one surface (first surface) 34a and the other surface (second surface) 34b. The two processing circuits 36 are provided respectively on the first surface 34a and the second surface 34b.

The processing circuit 36 provided on the first surface 34a is hereinafter also referred to as a first processing circuit 36A. The processing circuit 36 provided on the second surface 34b is hereinafter also referred to as a second processing circuit 36B.

The plurality of signal output terminals 38 are provided to electrically connect the plurality of external terminals 16a inserted into the plurality of inserted portions 22, to the plurality of processing circuits 36. The number of the signal output terminals 38 is the same as the number of the inserted portions 22. However, in order to avoid complication of the drawing, the number of the signal output terminals 38 shown in FIG. 3 is "4", and the other signal output terminals 38 are not shown.

The plurality of signal output terminals 38 are connected to the plurality of processing circuits 36. The number of the signal output terminals 38 connected to each processing circuit 36 is not particularly limited. The number of the signal output terminals 38 connected to each processing circuit 36 may be different. However, all the signal output terminals 38 are connected to any one of the plurality of processing circuits 36.

Each of the plurality of individual power terminals 40 is, for example, an electrode pad. The plurality of individual power terminals 40 are provided for electrical connection with a power supply. Each of the plurality of individual power terminals 40 is electrically connected to the power supply through the corresponding one of the power connectors 24 that are provided corresponding respectively to the individual power terminals 40.

The plurality of individual power terminals 40 are electrically connected respectively to the different processing circuits 36. The plurality of individual power terminals 40 include a first individual power terminal 40A and a second individual power terminal 40B. The first individual power terminal 40A is electrically connected to the first processing circuit 36A. The second individual power terminal 40B is electrically connected to the second processing circuit 36B.

Each of the plurality of common power terminals 42 is, for example, an electrode pad. The plurality of common power terminals 42 are electrically connected respectively to the different processing circuits 36. The plurality of common power terminals 42 include a first common power terminal 42A and a second common power terminal 42B. The first common power terminal 42A is electrically connected to the first processing circuit 36A. The second common power terminal 42B is electrically connected to the second processing circuit 36B.

The first common power terminal 42A and the first individual power terminal 40A are electrically connected to each other via a conductive wire 44a. The conductive wire 44a and the first processing circuit 36A are electrically connected to each other via a conductive wire 44b. Further, the second common power terminal 42B and the second individual power terminal 40B are electrically connected to each other via a conductive wire 44c. The conductive wire 44c and the second processing circuit 36B are electrically connected to each other via a conductive wire 44d.

FIG. 4 is a view showing a state in which the conductive member 32 is attached to the signal processing module 30 of FIG. 3.

The conductive member 32 is attachable to and detachable from the electronic device 10. The conductive member 32 has electrical conductivity. The conductive member 32 is in contact with the first common power terminal 42A and the second common power terminal 42B. As a result, the first common power terminal 42A and the second common power terminal 42B are electrically connected to each other.

The conductive member 32 is exposed to outside on the left side of the electronic device 10. Accordingly, the conductive member 32 can be electrically connected to the other unit 100 (100L) installed on the left side of the electronic device 10. The conductive member 32 is also exposed to outside on the right side of the electronic device 10. Accordingly, the conductive member 32 can be electrically connected to the other unit 100 (100R) installed on the right side of the electronic device 10. The conductive member 32 is substantially symmetrically exposed to outside on the left side of the electronic device 10 and the right side of the electronic device 10. However, the conductive member 32 may be asymmetrically exposed to outside on the left side of the electronic device 10 and the right side of the electronic device 10.

The dashed arrows in FIG. 4 simply illustrate the flow of electric power supply. As indicated by the dashed arrows, when the other unit 100L and the conductive member 32 are electrically connected to each other, power can be supplied from the other unit 100L to the first processing circuit 36A and the second processing circuit 36B. The conductive member 32 is also electrically connected to the other unit 100R. Therefore, power can be supplied also to the other unit 100R (the processing circuit of the other unit 100R) from the other unit 100L via the conductive member 32. Alternatively, power may be supplied to the first processing circuit 36A, the second processing circuit 36B, and the other unit 100L (the processing circuit of the other unit 100L) from the other unit 100R via the conductive member 32.

Alternatively, power may be supplied from the electronic device 10 to the other unit 100L and the other unit 100R. That is, the plurality of individual power terminals 40, the other unit 100L, and the other unit 100R are electrically connected via the conductive member 32. One of the plurality of individual power terminals 40 is connected to a power supply via the power connector 24. Thus, power can be supplied from the power supply to the other unit 100L and the other unit 100R via the electronic device 10.

The conductive member 32 may be removed from the electronic device 10. In this case, the first individual power terminal 40A is connected to a power supply. The first individual power terminal 40A is connected to the power supply through its own power connector 24. Thus, the power supply connected to the first individual power terminal 40A can supply electric power to the first processing circuit 36A. In addition, the second individual power terminal 40B may be connected to another power supply through its own power connector 24. Thus, the power supply connected to the second individual power terminal 40B can supply electric power to the second processing circuit 36B.

According to the present embodiment, the operator can easily change the number of processing circuits connected to one power supply. The operator can supply power from one power supply to a plurality of electronic devices 10 by attaching the conductive member 32 to the electronic device 10. This is preferable for the operator in that the number of required power supplies can be reduced. It is also preferable for the operator in that wiring of the power supply is simplified. On the other hand, the operator may remove the conductive member 32. This allows the operator to separate the plurality of processing circuits 36 into a plurality of groups. The plurality of processing circuits 36 receive power supply from different power supplies, for each group. Accordingly, for example, even when an abnormality occurs in one power supply, the processing circuits 36 of the groups corresponding to the power supplies other than the abnormal power supply can continue the operation. That is, the availability of the communication system 12 is secured.

### [Modifications]

Hereinafter, some specific examples of the exemplary modifications according to the embodiment will be described. However, components already described in the embodiment are denoted by the same reference numerals as in the embodiment. In addition, differences from the embodiment will be mainly described below, and redundant description will be omitted as much as possible.

### (Modification 1)

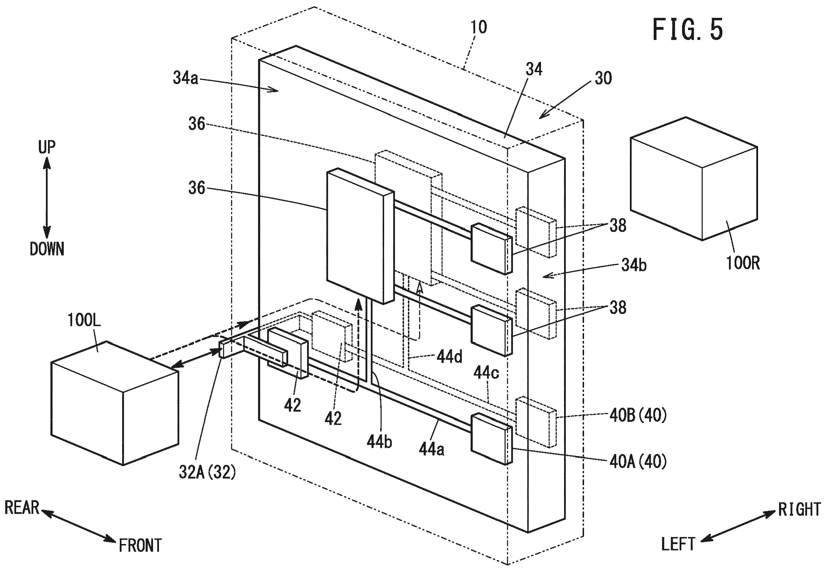

FIG. 5 is a diagram illustrating the electronic device 10 provided with the conductive member 32A (32) according to a first modification.

The conductive member 32A is a member that is electrically connected to one of the other unit 100L and the other unit 100R and to the plurality of processing circuits 36 of the electronic device 10. In the example of FIG. 5, the conductive member 32A is electrically connected to the other unit 100L and the plurality of processing circuits 36 of the electronic device 10. In this case, the electronic device 10 including the conductive member 32A can receive power supply from the other unit 100L. However, power may be supplied from the electronic device 10 to the other unit 100L. The other unit 100R is connected to a power supply different from the power supply that supplies power to the electronic device 10 and the other unit 100L.

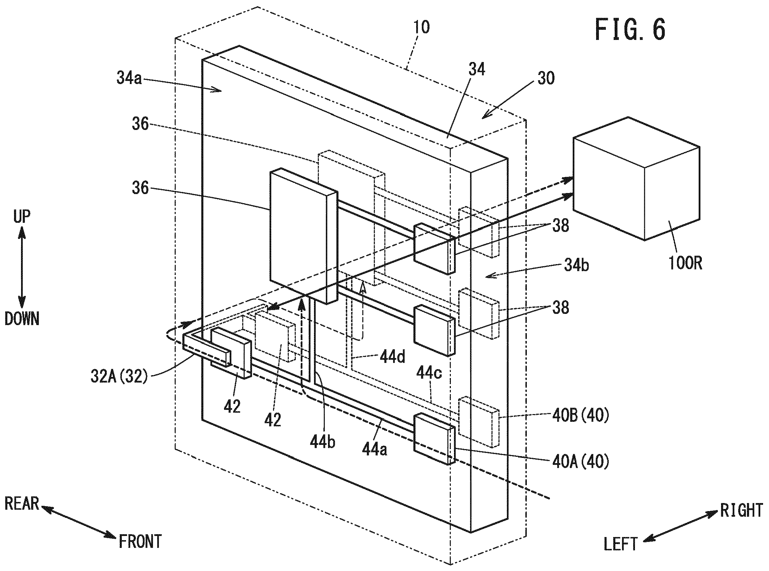

FIG. 6 is a diagram showing an electronic device 10 provided with a conductive member 32A according to a first modification, which is an example different from FIG. 5.

When the other unit 100R and the plurality of processing circuits 36 of the electronic device 10 are electrically connected to each other via the conductive member 32A, the electronic device 10 including the conductive member 32A can receive power supply from the other unit 100R. Power may be supplied from the electronic device 10 to the other unit 100R.

### (Modification 2)

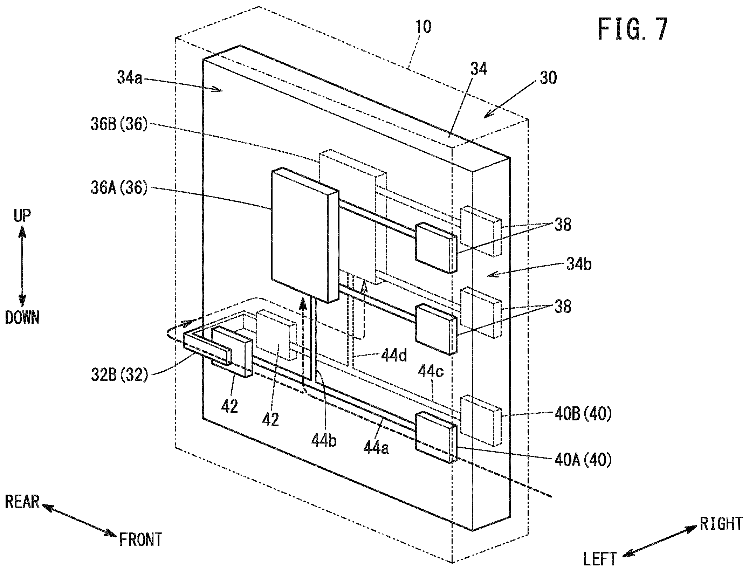

FIG. 7 is a diagram illustrating a state in which a power supply is connected to the individual power terminals 40 of the electronic device 10 provided with the conductive member 32B (32) according to a second modification.

The conductive member 32B is a member that is electrically connected to the plurality of processing circuits 36 (36A and 36B) of the electronic device 10 but is not electrically connected to the other units 100. In this case, one of the first individual power terminal 40A and the second individual power terminal 40B is connected to the power supply. Thus, power is supplied from the power supply to both the first individual power terminal 40A and the second individual power terminal 40B.

Note that each of the conductive member 32 of the embodiment, the conductive member 32A of the first modification, and the conductive member 32B of the present modification may be provided to the operator.

### (Modification 3)

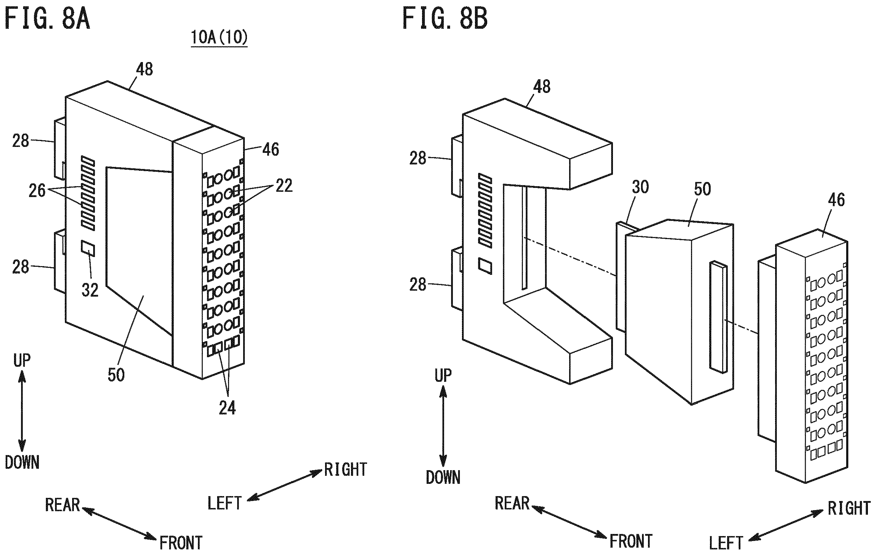

FIG. 8A is a diagram illustrating an electronic device 10A (10) according to a third modification. FIG. 8B is an exploded view of the electronic device 10A of FIG. 8A.

The electronic device 10A may be separable into a plurality of units. The electronic device 10A of the present modification can be separated into a connector unit (terminal block) 46, a base unit 48, and a signal processing unit 50. The connector unit 46, the signal processing unit 50, and the base unit 48 are arranged in this order in the rearward direction (FIG. 8B).

The connector unit 46 is a unit including the plurality of inserted portions 22 and the plurality of power connectors 24. The base unit 48 is a unit including the plurality of contactors 26 and the end engagement portions 28. The conductive member 32 is detachably installed on the base unit 48. The signal processing unit 50 is a unit including the signal processing module 30. By dividing the electronic device 10 into the plurality of units, maintenance work of the electronic device 10 can be easily performed.

The base unit 48 provided with the conductive member 32 and the base unit 48 not provided with the conductive member 32 may be separately provided to the operator. In addition, a base unit 48 which the conductive member 32 is attachable to and detachable from may be provided to the operator. Particularly in the former case, the operator can easily change the connection mode to the power supply simply by changing the base unit 48.

### (Modification 4)

The division of the electronic device 10 is not limited to the illustration in FIG. 8A. For example, the base unit 48 and the signal processing unit 50 may be integrally formed. Further, the signal processing unit 50 and the connector unit 46 may be integrally provided.

### [Inventions that can be Obtained from the Embodiment]

The inventions that can be grasped from the above-described embodiment and the modifications thereof will be described below.

The electronic device (10) that performs input and output of a signal, includes: the plurality of processing circuits (36) configured to perform input and output of the signal; the plurality of common power terminals (42) connected respectively to the different processing circuits to supply electric power to each of the plurality of processing circuits; the plurality of individual power terminals (40) connected respectively to the different processing circuits to supply electric power to each of the plurality of processing circuits; and the conductive member (32) attachably and detachably provided and configured to electrically connect the plurality of common power terminals to each other.

With this configuration, the electronic device in which the connection mode to the power supply can be easily changed is provided.

Each of the plurality of individual power terminals may be a terminal configured to connect a power supply and each of the processing circuits in order to supply electric power to each of the processing circuits. Thus, power can be supplied to the plurality of processing circuits by connecting a power supply to the plurality of individual power terminals.

The conductive member may be electrically connected to a first other electronic device (100L, 100R) adjacent to the electronic device in a first direction and may supply electric power supplied from the first other electronic device, to the plurality of processing circuits. With this configuration, power can be supplied from the first other electronic device to the plurality of processing circuits.

The conductive member may be electrically connected to the second other electronic device (100R, 100L) adjacent to the electronic device in a second direction opposite to the first direction and may supply the electric power to the second other electronic device. Accordingly, by supplying power to the electronic device, electric power can be supplied to the processing circuit of the second other electronic device.

The conductive member may supply electric power supplied from at least one of the plurality of individual power terminals, to the plurality of processing circuits. Thus, the number of necessary power supplies can be reduced.

The conductive member may be electrically connected to another electronic device (100R, 100L) adjacent to the electronic device in a predetermined installation direction and may supply the electric power to the other electronic device. Thus, by supplying electric power to the electronic device, electric power can be supplied to the processing circuit of the other electronic device.

The electronic device may further include the circuit board (34) including the first surface (34a) and the second surface (34b) and provided with the plurality of processing circuits, wherein the plurality of common power terminals may include at least one first common power terminal provided on the first surface and at least one second common power terminal provided on the second surface.

The electronic device may be divided into: the signal processing unit (50) including the plurality of processing circuits, the plurality of common power terminals, and the plurality of individual power terminals; and the base unit (48) that is attachable to and detachable from the signal processing unit and that is configured to detachably support the conductive member. This facilitates maintenance work of the electronic device.

The electronic device may further include the terminal block (46) configured to be connected to the device (16) serving as an input/output target of the signal, wherein the terminal block may be provided with connectors (24) configured to connect the plurality of individual power terminals to the plurality of power supplies.

The electronic device may be an I/O unit.

## Claims

1. An electronic device (10) that performs input and output of a signal, comprising:
a plurality of processing circuits (36) configured to perform input and output of the signal;
a plurality of common power terminals (42) connected respectively to the different processing circuits (36) to supply electric power to each of the plurality of processing circuits (36); and
a plurality of individual power terminals (40) connected respectively to the different processing circuits (36) to supply electric power to each of the plurality of processing circuits (36) ;
wherein the plurality of individual power terminals (40) are configured to be connectable to a power supply, **characterized in that**
a conductive member (32) attachably and detachably provided and configured to electrically connect the plurality of common power terminals (42) to each other,
wherein the conductive member (32) supplies electric power supplied from at least one of the plurality of individual power terminals (40), to the plurality of processing circuits (36).

2. The electronic device (10) according to claim 1, wherein
each of the plurality of individual power terminals (40) is a terminal configured to connect a power supply and each of the processing circuits (36) in order to supply electric power to the processing circuits (36) individually.

3. The electronic device (10) according to claim 1 or 2, wherein
the conductive member (32) is electrically connected to a first other electronic device that is adjacent to the electronic device (10) in a first direction and supplies electric power supplied from the first other electronic device, to the plurality of processing circuits (36).

4. The electronic device (10) according to claim 3, wherein
the conductive member (32) is electrically connected to a second other electronic device that is adjacent to the electronic device (10) in a second direction opposite to the first direction and supplies the electric power to the second other electronic device.

5. The electronic device (10) according to claim 1, wherein
the conductive member (32) is electrically connected to another electronic device that is adjacent to the electronic device (10) in a predetermined installation direction and supplies the electric power to the other electronic device.

6. The electronic device (10) according to any one of claims 1 to 5, further comprising a circuit board (34) including a first surface (34a) and a second surface (34b), and provided with the plurality of processing circuits (36),
wherein the plurality of common power terminals (42) comprise at least one first common power terminal provided on the first surface (34a) and at least one second common power terminal provided on the second surface (34b).

7. The electronic device (10) according to any one of claims 1 to 6, wherein
the electronic device (10) is divided into:
a signal processing unit (50) including the plurality of processing circuits (36), the plurality of common power terminals (42), and the plurality of individual power terminals (40); and
a base unit (48) that is attachable to and detachable from the signal processing unit (50) and that is configured to attachably and detachably support the conductive member (32).

8. The electronic device (10) according to any one of claims 1 to 7, further comprising a terminal block (46) configured to be connected to a device (16) serving as an input/output target of the signal,
wherein the terminal block (46) is provided with connectors (24) configured to connect the plurality of individual power terminals (40) to a plurality of power supplies.

9. The electronic device (10) according to any one of claims 1 to 8, wherein
the electronic device (10) is an I/O unit.

## Patentansprüche

1. Elektronisches Gerät (10), das die Ein- und Ausgabe eines Signals durchführt, mit:
einer Vielzahl von Verarbeitungsschaltungen (36), die so konfiguriert sind, dass sie die Ein- und Ausgabe des Signals durchführen;
einer Vielzahl von gemeinsamen Stromanschlüssen (42), die jeweils mit den verschiedenen Verarbeitungsschaltungen (36) verbunden sind, um jede der Vielzahl von Verarbeitungsschaltungen (36) mit elektrischer Energie zu versorgen; und
einer Vielzahl von individuellen Stromanschlüssen (40), die jeweils mit den verschiedenen Verarbeitungsschaltungen (36) verbunden sind, um jede der Vielzahl von Verarbeitungsschaltungen (36) mit elektrischer Energie zu versorgen;
wobei die Vielzahl von individuellen Stromanschlüssen (40) so konfiguriert ist, dass sie an eine Stromversorgung anschließbar sind,
**dadurch gekennzeichnet, dass**
ein leitfähiges Element (32) vorgesehen ist, das anbringbar und abnehmbar ist und so ausgebildet ist, dass es die mehreren gemeinsamen Stromanschlüsse (42) elektrisch miteinander verbindet,
wobei das leitfähige Element (32) die von mindestens einem der mehreren individuellen Stromanschlüsse (40) gelieferte elektrische Energie an die mehreren Verarbeitungsschaltungen (36) liefert.

2. Elektronisches Gerät (10) nach Anspruch 1, wobei jeder der mehreren einzelnen Stromanschlüsse (40) ein Anschluss ist, der so ausgelegt ist, dass er eine Stromversorgung mit jeder der Verarbeitungsschaltungen (36) verbindet, um die Verarbeitungsschaltungen (36) einzeln mit elektrischer Energie zu versorgen.

3. Elektronisches Gerät (10) nach Anspruch 1 oder 2, wobei das leitfähige Element (32) elektrisch mit einem ersten anderen elektronischen Gerät verbunden ist, das in einer ersten Richtung an das elektronische Gerät (10) angrenzt, und elektrische Energie, die von dem ersten anderen elektronischen Gerät geliefert wird, an die mehreren Verarbeitungsschaltungen (36) liefert.

4. Elektronisches Gerät (10) nach Anspruch 3, wobei das leitfähige Element (32) elektrisch mit einem zweiten anderen elektronischen Gerät verbunden ist, das dem elektronischen Gerät (10) in einer zweiten Richtung, die der ersten Richtung entgegengesetzt ist, benachbart ist, und das elektrische Strom an das zweite andere elektronische Gerät liefert.

5. Elektronisches Gerät (10) nach Anspruch 1, wobei das leitfähige Element (32) elektrisch mit einem weiteren elektronischen Gerät verbunden ist, das in einer vorgegebenen Einbaurichtung an das elektronische Gerät (10) angrenzt, und das elektrische Leistungsmittel an das weitere elektronische Gerät liefert.

6. Elektronisches Gerät (10) nach einem der Ansprüche 1 bis 5, das ferner eine Leiterplatte (34) umfasst, die eine erste Oberfläche (34a) und eine zweite Oberfläche (34b) aufweist und mit einer Vielzahl von Verarbeitungsschaltungen (36) versehen ist,
wobei die mehreren gemeinsamen Stromanschlüsse (42) mindestens einen ersten gemeinsamen Stromanschluss, der auf der ersten Oberfläche (34a) vorgesehen ist, und mindestens einen zweiten gemeinsamen Stromanschluss, der auf der zweiten Oberfläche (34b) vorgesehen ist, umfassen.

7. Elektronisches Gerät (10) nach einem der Ansprüche 1 bis 6, wobei das elektronische Gerät (10) unterteilt ist in:
eine Signalverarbeitungseinheit (50), die die mehreren Verarbeitungsschaltungen (36), die mehreren gemeinsamen Stromanschlüsse (42) und die mehreren individuellen Stromanschlüsse (40) umfasst; und
eine Basiseinheit (48), die an der Signalverarbeitungseinheit (50) anbringbar und von dieser abnehmbar ist und die so konfiguriert ist, dass sie das leitfähige Element (32) anbringbar und abnehmbar hält.

8. Elektronisches Gerät (10) gemäß einem der Ansprüche 1 bis 7, das ferner einen Anschlussblock (46) umfasst, der so ausgelegt ist, dass er mit einem Gerät (16) verbunden werden kann, das als Eingangs-/Ausgangsziel des Signals dient,
wobei der Anschlussblock (46) mit Steckverbindern (24) versehen ist, die so ausgelegt sind, dass sie die mehreren individuellen Stromanschlüsse (40) mit mehreren Stromversorgungen verbinden.

9. Elektronisches Gerät (10) nach einem der Ansprüche 1 bis 8, wobei das elektronische Gerät (10) eine E/A-Einheit ist.

## Revendications

1. Dispositif électronique (10) qui effectue l'entrée et la sortie d'un signal, incluant :
une pluralité de circuits de traitement (36) configurés pour effectuer l'entrée et la sortie du signal ;
une pluralité de bornes d'alimentation communes (42) connectées respectivement aux différents circuits de traitement (36) pour fournir de l'énergie électrique à chacun de la pluralité de circuits de traitement (36) ; et
une pluralité de bornes d'alimentation individuelles (40) connectées respectivement aux différents circuits de traitement (36) pour fournir de l'énergie électrique à chacun de la pluralité de circuits de traitement (36) ;
dans lequel la pluralité de bornes d'alimentation individuelles (40) sont configurées pour pouvoir être connectées à une source d'alimentation, **caractérisé en ce que**
un élément conducteur (32) est prévu de manière amovible et configuré pour connecter électriquement la pluralité de bornes d'alimentation communes (42) les unes aux autres,
dans lequel l'élément conducteur (32) fournit l'énergie électrique, provenant d'au moins une de la pluralité de bornes d'alimentation individuelles (40), à la pluralité de circuits de traitement (36).

2. Dispositif électronique (10) selon la revendication 1, dans lequel chacune de la pluralité de bornes d'alimentation individuelles (40) est une borne configurée pour connecter une source d'alimentation et chacun des circuits de traitement (36) afin de fournir de l'énergie électrique aux circuits de traitement (36) individuellement.

3. Dispositif électronique (10) selon la revendication 1 ou 2, dans lequel l'élément conducteur (32) est connecté électriquement à un premier autre dispositif électronique qui est adjacent au dispositif électronique (10) dans une première direction et fournit l'énergie électrique, provenant du premier autre dispositif électronique, à la pluralité de circuits de traitement (36).

4. Dispositif électronique (10) selon la revendication 3, dans lequel l'élément conducteur (32) est connecté électriquement à un deuxième autre dispositif électronique qui est adjacent au dispositif électronique (10) dans une deuxième direction opposée à la première direction et fournit l'énergie électrique au deuxième autre dispositif électronique.

5. Dispositif électronique (10) selon la revendication 1, dans lequel l'élément conducteur (32) est connecté électriquement à un autre dispositif électronique qui est adjacent au dispositif électronique (10) dans une direction d'installation prédéterminée et fournit de l'énergie électrique à l'autre dispositif électronique.

6. Dispositif électronique (10) selon une quelconque des revendications 1 à 5, incluant en outre une carte de circuit imprimé (34) incluant une première surface (34a) et une deuxième surface (34b) et pourvue de la pluralité de circuits de traitement (36),
dans lequel la pluralité de bornes d'alimentation communes (42) comprend au moins une première borne d'alimentation commune prévue sur la première surface (34a) et au moins une deuxième borne d'alimentation commune prévue sur la deuxième surface (34b).

7. Dispositif électronique (10) selon une quelconque des revendications 1 à 6, dans lequel le dispositif électronique (10) est divisé en :
une unité de traitement de signal (50) incluant la pluralité de circuits de traitement (36), la pluralité de bornes d'alimentation communes (42) et la pluralité de bornes d'alimentation individuelles (40) ; et
une unité de base (48) pouvant être fixée à l'unité de traitement de signal (50) et en être détachée et qui est configurée pour supporter l'élément conducteur (32) de manière amovible.

8. Dispositif électronique (10) selon une quelconque des revendications 1 à 7, incluant en outre un bloc de connexion (46) configuré pour être connecté à un dispositif (16) servant de cible d'entrée/sortie pour le signal,
dans lequel le bloc de connexion (46) est pourvu de connecteurs (24) configurés pour connecter la pluralité de bornes d'alimentation individuelles (40) à une pluralité d'alimentations électriques.

9. Dispositif électronique (10) selon une quelconque des revendications 1 à 8, dans lequel
le dispositif électronique (10) est une unité d'entrée/sortie.
